(19) Europäisches Patentamt / European Patent Office / Office européen des brevets

(11) **EP 2 897 296 B1**

(12) **EUROPEAN PATENT SPECIFICATION**

(45) Date of publication and mention
of the grant of the patent:
**08.05.2019 Bulletin 2019/19**

(21) Application number: **13837064.8**

(22) Date of filing: **17.09.2013**

(51) Int Cl.:
*H04B 1/04* (2006.01)     *H03F 1/06* (2006.01)
*H03F 3/217* (2006.01)    *H03F 3/68* (2006.01)

(86) International application number:
**PCT/JP2013/074994**

(87) International publication number:
**WO 2014/042270 (20.03.2014 Gazette 2014/12)**

(54) **TRANSMITTER**

SENDER

ÉMETTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.09.2012 JP 2012202592**

(43) Date of publication of application:
**22.07.2015 Bulletin 2015/30**

(73) Proprietor: **NEC Corporation
Tokyo 108-8001 (JP)**

(72) Inventors:
• **HORI, Shinichi
Tokyo 108-8001 (JP)**
• **KUNIHIRO, Kazuaki
Tokyo 108-8001 (JP)**
• **SHIIKUMA, Kazumi
Tokyo 108-8001 (JP)**

(74) Representative: **Vossius & Partner
Patentanwälte Rechtsanwälte mbB
Siebertstrasse 3
81675 München (DE)**

(56) References cited:
EP-A1- 1 168 632          WO-A1-2011/070952
JP-A- 2001 265 395        JP-A- 2005 086 611
JP-A- 2006 254 307        JP-A- 2011 091 757
US-A1- 2002 131 521       US-A1- 2004 190 660
US-A1- 2005 148 307       US-A1- 2010 117 727
US-B1- 6 501 405

• SHEHATA K A ET AL: "An FPGA based 1-bit all digital transmitter employing Delta-Sigma Modulation with RF output for SDR", SIGNALS, CIRCUITS AND SYSTEMS, 2008. SCS 2008. 2ND INTERNATIONAL CONFERENCE ON, IEEE, PISCATAWAY, NJ, USA, 7 November 2008 (2008-11-07), pages 1-6, XP031405879, ISBN: 978-1-4244-2627-0

• TSAI-PI HUNG ET AL.: 'Design of H-Bridge Class-D Power Amplifiers for Digital Pulse Modulation Transmitters' IEEE TRANS. MICROWAVE THEORY AND TECHNIQUES vol. 55, no. 12, December 2007, pages 2845 - 2855, XP011197404

**Description**

TECHNICAL FIELD

The present invention relates to a transmitter for use in communication and broadcasting equipment such as mobile phone systems, radio LAN (Local Area Network) equipment and others.

BACKGROUND ART

Requirements for transmitters used in communication and broadcasting equipment, such as mobile phone systems, radio LAN equipment and others include low power consumption while ensuring that the waveform is maintained at a high accuracy regardless of the transmission power level. In particular, the requirement is that amplifiers transmit power with high efficiency because transmission power amplifiers that are placed at the final stage of the transmitter consume a large amount of power.

Recently, switching amplifiers have attracted attention as power amplifiers that are expected provide high power efficiency. A switching amplifier is assumed to receive pulse waveform signals as its input signals, and amplifies the power of the signal while maintaining the pulse waveform. The pulse waveform that is signal amplified by the switching amplifier is processed through a filter element so that frequency components other than the desired radio signal band are received, then are radiated from an antenna.

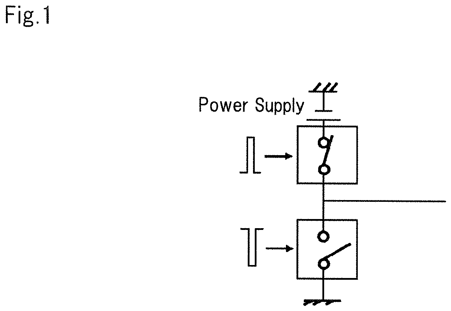

FIG. 1 is a circuit diagram showing a configurational example of a power amplifier called a class-D or class-S amplifier (which will be referred to hereinbelow as class-D amplifier as a representative) as a typical example of the switching amplifier. FIG. 1 shows a configurational example of a class-D amplifier that amplifies binary signals taking two levels, i.e., logic '1' or '0' (which will be referred to hereinbelow as a binary class-D amplifier).

The binary class-D amplifier shown in FIG. 1 is composed of switching elements inserted between a power supply and an output terminal and between the output terminal and the ground potential. The two switching elements are supplied with complementary pulse signals as open/close control signals so that only one of the switching elements will be turned on. From the class-D amplifier shown in FIG. 1, the same voltage as that of the power supply (high level: logic '1') is output when the switching element on the power supply side is ON and the switching element on the ground potential side is OFF, whereas the ground potential (low level: logic '0') is output when the switching element on the power supply side is OFF and the switching element on the ground potential side is ON.

Since the class-D amplifier shown in FIG. 1 needs no bias current, the ideal situation is one in which the power loss is zero. The switching elements may use field effect transistors, bi-polar transistors and the like.

As the transmitter using the binary class-D amplifier shown in FIG. 1, for example a binary transmitter combined with a $\Delta\Sigma$ (delta-sigma) modulator that converts baseband signals into binary signals has been known. In the binary transmitter, the digital baseband signal that has been converted into binary signal by $\Delta\Sigma$ modulation, is amplified to a desired level by the binary class-D amplifier shown in FIG. 1, then output to the antenna via a filter.

Further, examples of the switching amplifier may include a class-D amplifier that amplifies signals that have logical values with multiple numbers of bits (which will be referred to hereinbelow as multilevel class-D amplifier), so that multilevel transmitters including the multilevel class-D amplifier in combination with a multilevel $\Delta\Sigma$ modulator that converts the baseband signals into multilevel signals, have been also known.

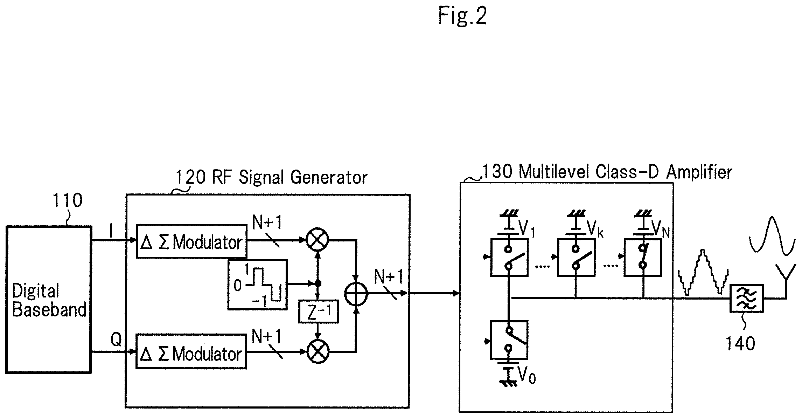

FIG. 2 is a block diagram showing a configuration of a multilevel transmitter of the background art, equipped with multilevel $\Delta\Sigma$ modulators and a multilevel class-D amplifier.

The multilevel transmitter shown in FIG. 2 includes digital baseband circuit (Digital Baseband) 110, RF signal generator 120 including multilevel $\Delta\Sigma$ modulators, multilevel class-D amplifier 130 and filter 140.

RF signal generator 120 performs multilevel $\Delta\Sigma$ modulation on each of two orthogonal signals (I-signal and Q-signal) generated by a digital baseband circuit 110 and upconverts the signals after multilevel $\Delta\Sigma$ modulation to the desired radio signal frequency and outputs the sum of the two signals after upconversion. The output signal from RF signal generator 120 is decoded by an unillustrated decoder, so that the decoded signal drives multiple switching elements (described later) included in multilevel class-D amplifier 130.

Multilevel class-D amplifier 130 includes a plurality of power supplies $V_0$ to $V_N$ (N is an integer equal to or greater than 0) different in output voltage (d.c. voltage) and a switch group composed of a plurality of switching elements, each inserted between one of multiple power supplies $V_1$ to $V_N$ and the output terminal and inserted between the output terminal and ground potential $V_0$. Multilevel class-D amplifier 130, based on the output signal from RF signal generator 120, turns ON one corresponding switching element to output the power supply voltage or ground potential to be supplied to the turned-ON switching element. The radio signal amplified by multilevel class-D amplifier 130 is output to the antenna via filter 140.

Since the multilevel transmitter shown in FIG. 2 can put logical values with multiple numbers of bits on the sending signal, this transmitter has the advantage of low quantized noise arising from the $\Delta\Sigma$ modulators and an improved signal-to-noise power ratio, compared to the binary transmitter including the binary class-D amplifier shown in FIG. 1. The configurational examples of the above binary transmitter and multilevel transmitter have also been proposed by Patent Documents 1 and 2, for example.

As described above, the multilevel transmitter shown in FIG. 2 is improved in signal-to-noise power ratio compared to the binary transmitter including the binary class-D amplifier shown in FIG. 1. However, since the multilevel transmitter needs a plurality of power supplies different in output voltage (d.c. voltage) for configuring the multilevel class-D amplifier, this entails a problem in which the cost of the entire apparatus increases. Therefore, this has given rise to the requirement of a transmitter being able to achieve an improved signal-to-noise power ratio without use of a multilevel class-D amplifier. Patent Documents 1 and 2 show techniques for improving the power efficiency of the class-D amplifier, but do not present any technique for improving the signal-to-noise power ratio of the transmitter.

Related Art Documents

Patent Document

Patent Document 1: JP2011-077979A
Patent Document 2: WO 2001/078120

Patent Document JP2001265395 A which discloses digital audio data transmission device suitable for transmitting encrypted data.
Document EP1168632 A1 discloses a transmitter device using configurable sigma-delta modulators.
Document "An FPGA based 1-bit all digital transmitter employing Delta-Sigma Modulation with RF output for SDR"by Shehata K and Al discloses an example of a digital transmitter.

SUMMARY

It is therefore an object of the present invention to provide a transmitter including a class-D amplifier that can achieve an improved signal-to-noise power ratio.
In order to achieve the above object, the transmitter according to claim 1 is provided.

BRIEF DESCRIPTION OF DRAWINGS

FIG. 1 is a circuit diagram showing a configurational example of a class-D amplifier as a representative example of a switching amplifier.
FIG. 2 is a block diagram showing a configuration of a background art multilevel transmitter including multilevel $\Delta\Sigma$ modulators and a multilevel class-D amplifier.
FIG. 3 is a block diagram showing one configurational example of a transmitter of the first exemplary embodiment.
FIG. 4 is a block diagram showing one configurational example of a $\Delta\Sigma$ modulator.
FIG. 5 is a circuit diagram showing other insert examples of the changeover switch shown in FIG. 3.
FIG. 6 is a block diagram showing another configurational example of a transmitter of the first exemplary embodiment.
FIG. 7 is a block diagram showing another configurational example of a transmitter of the first exemplary embodiment.
FIG. 8 is a circuit diagram showing another configurational example of a combiner that is applicable to the transmitter shown in FIG. 3.
FIG. 9 is a circuit diagram showing another configurational example of a combiner that is applicable to the transmitter shown in FIG. 3.
FIG. 10 is a block diagram showing one configurational example of a transmitter of the second exemplary embodiment.
FIG. 11 is a block diagram showing one configurational example of a transmitter of the third exemplary embodiment.

EXEMPLARY EMBODIMENT

Next the present invention will be described with reference to the drawings.

(The First Exemplary Embodiment)

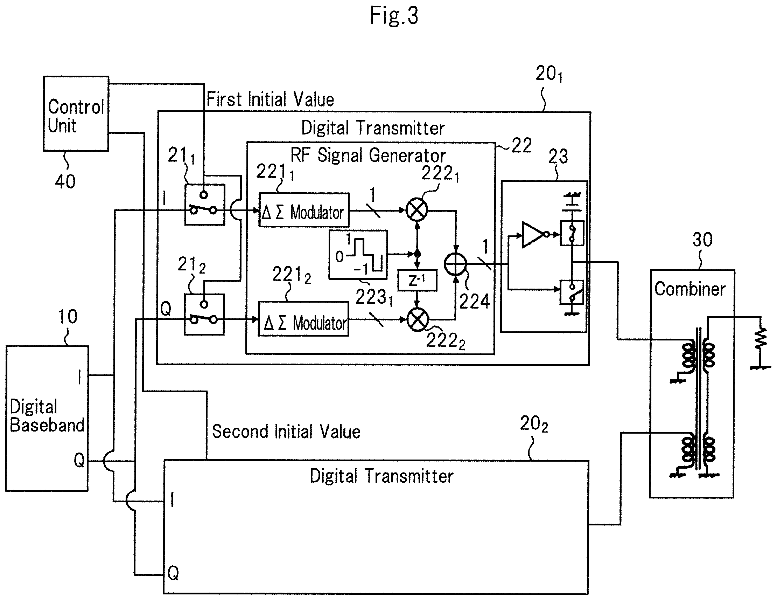

FIG. 3 is a block diagram showing one configurational example of a transmitter of the first exemplary embodiment.

The transmitter shown in FIG. 3 includes digital baseband circuit (Digital baseband) 10, two digital transmitters $20_1$ and $20_2$, combiner 30 and control unit 40.

Digital baseband circuit 10 modulates two signals orthogonal to each other in accordance with the transmit information as the signals to be transmitted, to produce and output two baseband signals (I-signal and Q-signal). The I-signal and Q-signal generated by digital baseband circuit 10 are input to digital transmitters $20_1$ and $20_2$. That is, digital transmitters $20_1$ and $20_2$ are supplied with the same I-signal and Q-signal.

Digital transmitters $20_1$ and $20_2$ each include changeover switches $21_1$ and $21_2$, RF signal generator 22 and class-D amplifier 23.

RF signal generator 22 included in digital transmitters $20_1$ and $20_2$ shown in FIG. 3 is equivalent to one in which the multilevel RF signal generator 120 shown in FIG. 2 is replaced by a configuration that outputs two levels (logic '1' and '0') while class-D amplifier 23 uses the binary class-D amplifier shown in FIG. 1.

Changeover switches $21_1$ and $21_2$ are used as input means that supplies the first initial value or the second initial value to the input terminal of an aftermentioned $\Delta\Sigma$ modulator, or the internal node of the $\Delta\Sigma$ modulator, that is included in RF signal generator 22.

The first initial value and the second initial value are generated by control unit 40 that is provided in the communication equipment including the transmitter and receiver of the present invention such as a mobile phone, radio LAN device and the like and controls the operation of the entire communication device, and that is supplied to digital transmitters $20_1$ and $20_2$. Control unit 40 can be realized by an information processing IC (micro computer) or the like that executes processes in accordance with a program, for example.

Changeover switch $21_1$ is provided corresponding to the I-signal supplied from digital baseband circuit 10 to receive input of the first initial value supplied from the outside and the I-signal supplied from digital baseband circuit 10. Changeover switch $21_1$ supplies the first initial value from the outside to RF signal generator 22 in the initial state of the transmitter and supplies the I-signal from digital baseband circuit 10 to RF signal generator 22 after the initial state, in accordance with the control signal input from the control unit 40 or the like.

Changeover switch $21_2$ is provided corresponding to the Q-signal supplied from digital baseband circuit 10 to receive input of the first initial value supplied from the outside and the Q-signal supplied from digital baseband circuit 10. Changeover switch $21_2$ supplies the first initial value from the outside to RF signal generator 22 in the initial state of the transmitter and supplies the Q-signal from digital baseband circuit 10 to RF signal generator 22 after the initial state, in accordance with the control signal input from control unit 40 or the like. The first initial value is a fixed value generated by and supplied from the aforementioned control unit 40, for example.

RF signal generator 22 includes two $\Delta\Sigma$ modulators $221_1$ and $221_2$ arranged for the I-signal and the Q-signal, respectively, two multipliers $222_1$ and $222_2$ arranged for the I-signal and the Q-signal, respectively, local signal generator 223, and adder 224.

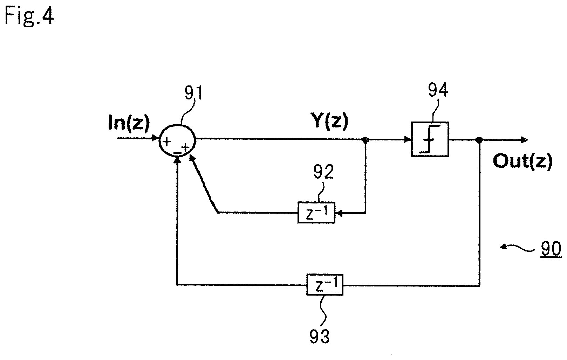

$\Delta\Sigma$ modulators $221_1$ and $221_2$ perform primary $\Delta\Sigma$ modulation on the input signals. $\Delta\Sigma$ modulators $221_1$ and $221_2$ for performing primary $\Delta\Sigma$ modulation can be realized by the configuration shown in FIG. 4, for example.

FIG. 4 is a block diagram showing one configurational example of the $\Delta\Sigma$ modulator.

$\Delta\Sigma$ modulator 90 shown in FIG. 4 includes adder 91, first delay unit 92, second delay unit 93 and comparator 94.

Input signal In(z) to $\Delta\Sigma$ modulator 90 shown in FIG. 4 is supplied to adder 91. Output signal Y(z) from adder 91 is delayed by first delay unit 92 and then positively fed back to adder 91. Also, output signal Y(z) from adder 91 is converted into binary signals by comparator 94 and is output as output signal Out(z). Output signal Out(z) is delayed by second delay unit 93, and then negatively fed back to adder 91.

In this configuration, the feedback loop composed of adder 91 and first delay unit 92 forms an integrator, so that the relational equation between input signal In(z) and output signal Out(z) holds as follows:-

$$\text{Out}(z) = \text{In}(z) + (1- z^{-1}) \cdot \text{N}(z),$$

where N(z) represents quantized error.

Multipliers $222_1$ and $222_2$ provided for RF signal generator 22 shown in FIG. 3 are frequency converters that upconvert the signals output from $\Delta\Sigma$ modulators $221_1$ and $221_2$, into desired radio signal frequencies, using pulse train signals generated by local signal generator 223.

Adder 224 adds up the signals output from the two multipliers $222_1$ and $222_2$ and outputs the result.

The output signal from adder 224 is amplified by class-D amplifier 23 to the desired level and output.

Digital transmitter $20_2$ shown in FIG. 3 has the same configuration as that of aforementioned digital transmitter $20_1$, except in that the second initial value that is different from the first initial value is input to RF signal generator 22 in the initial state. Similarly to the first initial value, the second initial value is a fixed value generated and supplied by control unit 40.

Combiner 30 combines the output signals from two digital transmitters $20_1$ and $20_2$ and supplies the resultant signal to the load. As shown in FIG. 3, combiner 30 is embodied by a transformer having two primary windings to which the output signals from digital transmitters $20_1$ and $20_2$ are individually input and two secondary windings that are provided corresponding to the primary windings, connected in series. Output from combiner 30 shown in FIG. 3 is the sum of the output voltage from digital transmitter $20_1$ and the output voltage from digital transmitter $20_2$. The radio signal output from combiner 30 is output to the antenna via an unillustrated filter, for example.

In this configuration, since output signal Tx1(t) from digital transmitter $20_1$ includes radio signal S(t) and quantized noise N1(t) arising at ΔΣ modulators $221_1$ and $221_2$, output signal Tx1(t) from digital transmitter $20_1$ can be represented by the following equation (1):-

$$Tx1(t) = S(t) + N1(t) \cdots (1)$$

As described above, in digital transmitter $20_1$ the first initial value is input to ΔΣ modulators $221_1$ and $221_2$ in the initial state.

On the other hand, when radio signals are transmitted, the I-signal and Q-signal generated by digital baseband circuit 10 are input to ΔΣ modulators $221_1$ and $221_2$.

Here, quantized noise N1(t) on the right side of the above Eq. (1) depends on the first initial value as shown below.

For example, when ΔΣ modulator 90 shown in FIG. 4 is used for ΔΣ modulators $221_1$ and $2212$, if the input signals to ΔΣ modulator 90 are In(0), In(1), In(2), •••, n(n), Y(n), the output signal from adder 91 is represented by the following equation (101).
[Math 1]

$$Y(n) = Y(n-1) + In(n) - Out(n-1) \cdots (101)$$

Eq. (101) can be expanded as the following equation (102)
[Math 2]

$$Y(n) = Y(0) + \sum_{k=1}^{n} \{In(k) - Out(k-1)\} \cdots (102)$$

The second term on the right side of the above Eq. (102) is the summation of the differences between the current input signal and the past output signal, expressing the operation of the integrator composed of adder 91 and first delay unit 92. That is, the output signal from adder 91 depends on the initial value, Y(0) of the output signal from adder 91. Further, when considering that Y(0), the initial value of the output signal from adder 91, is determined by addition and subtraction of In(0), the initial value of the input signal, Out(0), the initial value of the output signal and Y(-1), the past output signal of adder 91, it is known that Y(n), the output signal of adder 91, also depends on In(0), the initial value of the input signal, and Out(0), the initial value of the output signal.

Quantized noise N(n) arising at comparator 94 shown in FIG. 4 is the difference between Out(n), the output signal, and Y(n), the output signal of adder 91, and is represented by the following equation (103).
[Math 3]

$$N(0) = Out(n) - Y(0) + \sum_{k=1}^{n} \{In(k) - Out(k-1)\} \cdots (103)$$

It is understood from the above Eq. (103), quantized noise N(n) also depends on Y(0), the initial value of the output signal from adder 91, or In(0), the initial value of the input signal, and Out(0), the initial value of the output signal.

Herein, signal-to-noise power ratio SNR1 of the output from digital transmitter $20_1$ shown in FIG. 3 is expressed by the following equation (2) using the time square average of radio signal S(t) and the time square average of quantized noise N1(t).
[Math 4]

$$SNR1 = \overline{S(t)^2}\Big/\overline{N1(t)^2} \quad \cdots(2)$$

Further, since Tx2(t), the output signal from digital transmitter $20_2$ shown in FIG. 3, includes radio signal S(t) and quantized noise N2(t) arising at $\Delta\Sigma$ modulators $221_1$ and $221_2$, Tx2(t), the output signal from digital transmitter $20_2$, can be expressed by the following equation (3).

$$Tx2(t) = S(t) + N2(t) \quad \bullet\bullet\bullet (3)$$

In digital transmitter $20_2$ the second initial value is input to $\Delta\Sigma$ modulators $221_1$ and $221_2$ in the initial state.

On the other hand, when radio signals are transmitted, the I-signal and Q-signal generated by digital baseband circuit 10 are input to $\Delta\Sigma$ modulators $221_1$ and $221_2$.

Herein, the signal-to-noise power ratio SNR2 in digital transmitter $20_2$ is expressed by the following equation (4) using the time square average of radio signal S(t) and the time square average of quantized noise N1(t).
[Math 5]

$$SNR2 = \overline{S(t)^2}\Big/\overline{N2(t)^2} \quad \cdots(4)$$

In digital transmitters $20_1$ and $20_2$, the initial values of the input signals to $\Delta\Sigma$ modulators $221_1$ and $221_2$ are different from each other as described above. Accordingly, the quantized noises N1(z) and N2(z) given by the above equation (103) are not equal. On the other hand, because of the statistical nature of noise, the time square averages of quantized noises N1(z) and N2(z) become equal to each other. That is, the following equation (5) holds.
[Math 6]

$$\overline{N1(t)^2}\Big/\overline{N2(t)^2} \quad \cdots(5)$$

It is understood from this that even if the initial values of the input signals are different, the signal-to-noise power ratio in digital transmitter $20_1$ and the signal-to-noise power ratio in digital transmitter $20_2$ given by equations (2) and (4) are equal to each other.

Combiner 30 combines the output signal from digital transmitter $20_1$ and the output signal from digital transmitter $20_2$. Accordingly, Com1(1), the output from combiner 30, is equal to the sum of the right side of the above Eq. (1) and the right side of the above Eq. (3). That is,

$$Com1(1) = 2S(t) + N1(t) + N2(t) \quad \bullet\bullet\bullet (6)$$

holds.

On the other hand, SNRcom, the signal-to-noise power ratio in the output from combiner 30, is represented by the following Eq. (7).
[Math 7]

$$SNR_{com} = 4 \cdot \overline{S(t)^2}\Big/\overline{(N1(t)+N2(t))^2} \quad \cdots(7)$$

In the denominator on the right side of Eq. (7), since quantized noises N1(t) and N2(t) are unequal to each other as described above, the time average of the product of quantized noises N1(t) and N2(t) becomes zero based on the statistic characters of noise. As a result, the denominator on the right side of Eq. (7) can be expanded as shown in the following equation (8)
[Math 8]

$$\overline{(N1(t)+N2(t))^2} = \overline{N1(t)^2} + \overline{N2(t)^2} \quad \cdots(8)$$

From the above Eq. (8) and Eq. (5), Eq. (7) can be rewritten as the following Eq. (9).

[Math 9]

$$SNR_{com} = 2 \cdot \overline{S(t)^2} \Big/ \overline{N1(t)^2} \quad \cdots (9)$$

As understood from Eq. (9), SNRcom, the signal-to-noise power ratio in the output of combiner 30 is equal to the double of SNR1, the signal-to-noise power ratio in the output of digital transmitter $20_1$ (= SNR2, the signal-to-noise power ratio in the output of digital transmitter $20_2$).

This means that the configuration shown in FIG. 3 can improve the signal-to-noise power ratio compared to a configuration having only a single digital transmitter with no initial value provided.

Further, in the transmitter shown in FIG. 3, digital transmitters $20_1$ and $20_2$ have the same configuration and the power supply voltages that are to be used by class-D amplifier 24 in each are equal. Accordingly, it is possible to use a single common power supply voltage in class-D amplifiers 24.

As a result, without using multilevel class-D amplifier 130 that requires a plurality of power supplies as shown in FIG. 2, it is possible to provide a transmitter that can improve signal-to-noise power ratio. Further, it is possible to hold down the sampling frequency or the over sampling ratio of $\Delta\Sigma$ modulators $221_1$ and $221_2$ that is required to obtain the equivalent signal-to-noise power ratio, cut down the power consumption of the $\Delta\Sigma$ modulators, and hence reduce the power consumption of the transmitter as a whole.

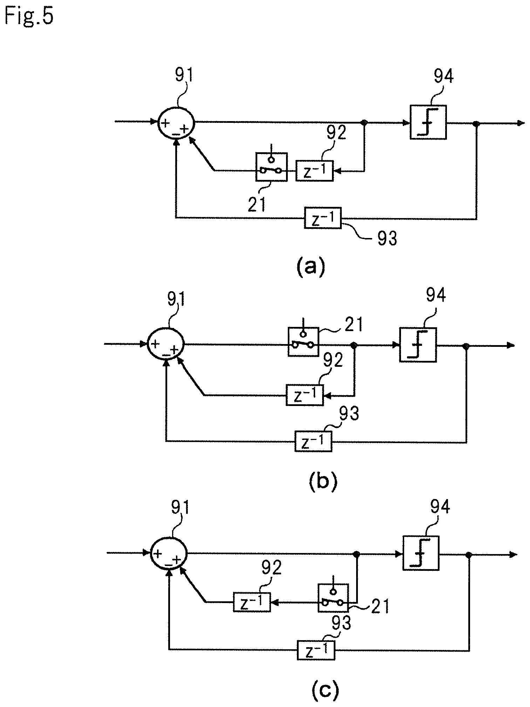

The node to which the initial value is supplied to RF signal generator 22 is not limited to the input terminals of $\Delta\Sigma$ modulators $221_1$ and $221_2$ as shown in FIG. 3, but the internal nodes of $\Delta\Sigma$ modulators $221_1$ and $221_2$ may be adopted. FIGS. 5(a) to 5(c) show configurational examples in which changeover switch 21 is inserted in the feedback loop of adder 91 and first delay unit 92 that forms an integrator in the primary $\Delta\Sigma$ modulator 90 shown in FIG. 4. Further, changeover switch 21 should not be limited to the positions shown in FIGS. 5(a), 5(b) and 5(c), but may be inserted in other internal nodes of $\Delta\Sigma$ modulators $221_1$ and $221_2$. Moreover, in a well-known higher order $\Delta\Sigma$ modulator, changeover switches may be inserted inside the feedback loop that forms an integrator or at another internal node to supply the initial value. With such a configuration, it is also possible to have the same effect as the above configuration where the initial value is supplied to the input terminal of $\Delta\Sigma$ modulator 90.

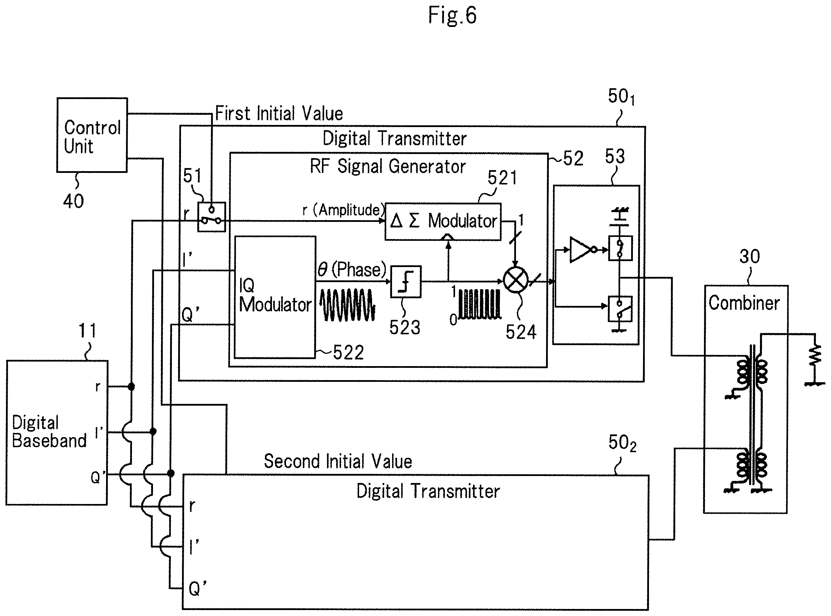

The RF signal generator provided in the digital transmitter of the present exemplary embodiment may be replaced by the configuration shown in FIG. 6. RF signal generator 52 shown in FIG. 6 is one that is described in FIG. 1(c) of Non-patent Document 1 (S. Hori, K. Kunihiro, K. Takahashi and M. Fukaishi, "A 0.7-3GHz envelope delta-sigma modulator using phase modulated carrier clock for multi-mode/band switching amplifiers", IEEE Radio Frequency Integrated Circuits Symposium Digest, pp. 35-38, June 2011).

FIG. 6 is a block diagram showing another configurational example of a transmitter of the first exemplary embodiment.

The transmitter shown in FIG. 6 includes digital baseband circuit 11, two digital transmitters $50_1$ and $50_2$, combiner 30 and control unit 40. The configuration and operation of combiner 30 is the same as in the transmitter shown in FIG. 3.

Digital baseband circuit 11 generates and outputs amplitude signal r which is the amplitude component of the baseband signal and phase orthogonal signals (I'-signal, Q'-signal) that are obtained by dividing two baseband signals (I-signal, Q-signal) that are orthogonal to each other by amplitude signal r. The amplitude signal r, I'-signal and Q'-signal generated by digital baseband circuit 11 are supplied to each of two digital transmitters $50_1$ and $50_2$.

Digital transmitters $50_1$ and $50_2$ each include changeover switch 51, RF signal generator 52 and class-D amplifier 53. The configuration and operation of changeover switch 51 is the same as that of changeover switch $21_1$ (or $21_2$) shown in FIG. 3. In the configuration shown in FIG. 6, in the initial state the first initial value is input to RF signal generator 52 of digital transmitter $50_1$ while the second initial value is input to RF signal generator 52 of digital transmitter $50_2$. Class-D amplifier 53 uses the binary class-D amplifier shown in FIG. 1, as in the digital transmitter $20_1$ shown in FIG. 3.

RF signal generator 52 includes $\Delta\Sigma$ modulator 521 provided for amplitude signal r, IQ modulator (orthogonal modulator) 522 that converts I'-signal and Q'-signal into RF band phase signals, comparator 523 that converts the RF band phase signals output from IQ modulator 522 into rectangular pulse phase signals, and adder 524 that adds up the output signals from $\Delta\Sigma$ modulator 521 and comparator 523. $\Delta\Sigma$ modulator 521 performs $\Delta\Sigma$ modulation on amplitude signal r, using the pulse phase signal (RF band phase signal) output from comparator 523 as a clock signal. Multiplier 524 combines the output signal from $\Delta\Sigma$ modulator 521 and the RF band phase signal and outputs the result.

Digital transmitter $50_2$ has the same configuration as that of digital transmitter $50_1$ except that the second initial value that is different from the first initial value is input to RF signal generator 52 in the initial state. The first initial value and the second initial value are generated and supplied by control unit 40 similarly to the transmitter shown in FIG. 3.

Similarly to the transmitter shown in FIG. 3, also in the transmitter shown in FIG. 6 it is possible to provide a transmitter that can achieve an improved signal-to-noise power ratio without using a multilevel class-D amplifier that requires a plurality of power supplies. Further, it is possible to hold down the sampling frequency or the over sampling ratio of $\Delta\Sigma$ modulator 521 that is required to obtain the equivalent signal-to-noise power ratio, and therefore decrease power consumption of the $\Delta\Sigma$ modulator 521 and reduce power consumption of the transmitter as a whole.

Here, the configuration shown in the present exemplary embodiment may also be applied to a transmitter including an RF signal generator with a multilevel $\Delta\Sigma$ modulator, and a multilevel class-D amplifier.

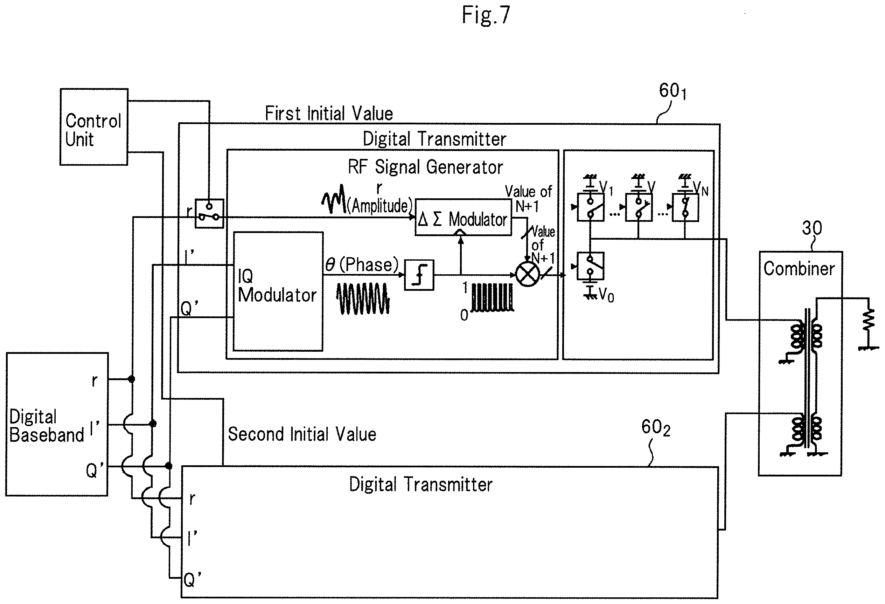

For example, in the transmitter shown in FIG. 6, RF signal generator 52 may be replaced by an RF signal generator with multilevel outputs while class-D amplifier 53 may be replaced by a multilevel class-D amplifier. FIG. 7 shows a configurational example of such a multilevel transmitter.

FIG. 7 is a block diagram showing another configurational example of a transmitter of the first exemplary embodiment.

The $\Delta\Sigma$ modulator included in the RF signal generator shown in FIG. 7 outputs the same number of values as that of the voltage values output by a multilevel class-D amplifier in the downstream stage. The output signal from the RF signal generator is decoded by a decoder that is not shown. The signal after decoding is amplified by a driver amplifier and then supplied to the multilevel class-D amplifier.

The multilevel class-D amplifier, similarly to that in the multilevel transmitter shown in FIG. 2, includes a plurality of power supplies $V_0$ to $V_N$ (N is an integer equal to or greater than 0) different in output voltage (d.c. voltage) and a switch group of a plurality of switching elements, each inserted between any one of multiple power supplies $V_1$ to $V_N$ and the output terminal and inserted between the output terminal and ground potential $V_0$, and amplifies the output signal from the RF signal generator to turn on and off the corresponding switching elements in accordance with the output signal from the driver amplifier.

Since, in the transmitter shown in FIG. 7, digital transmitters $60_1$ and $60_2$ each include multilevel class-D amplifier, the signal-to-noise power ratio is improved compared to the configurations that includes a binary class-D amplifier shown in FIGS. 3 and 6. That is, the transmitter shown in FIG. 7, in which different initial values are input to the multilevel $\Delta\Sigma$ modulators in two digital transmitters $60_1$ and $60_2$ in the initial state, combines the output signals from these two digital transmitters $60_1$ and $60_2$, so that it is possible to further improve the signal-to-noise power ratio compared to the binary transmitters shown in FIGS. 3 and 6.

Further, in the present exemplary embodiment, it is possible in the transmitter shown in FIG. 3 to replace RF signal generator 22 by multilevel output RF signal generator 120 shown in FIG. 2 and replace class-D amplifier 23 by multilevel class-D amplifier 130 shown in FIG. 2. The thus configured multilevel transmitter can also present the same effect as that of the transmitter FIG. 7.

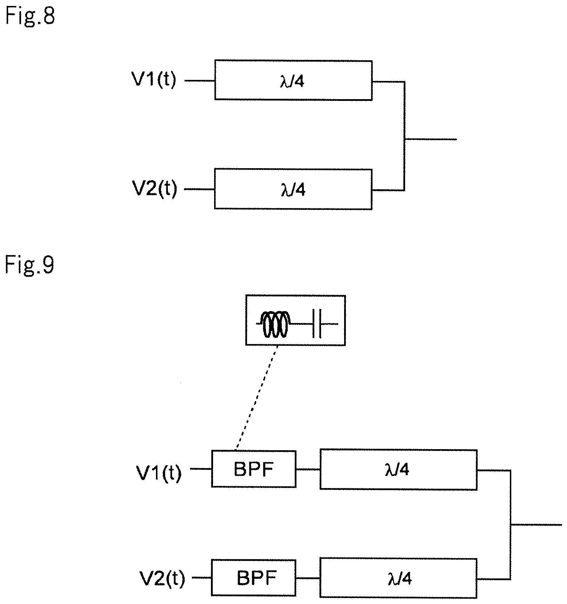

Combiners 30 shown in FIGS. 3, 6 and 7 may be realized by another circuit. FIGS. 8 and 9 show other configurational examples of combiner 30 that can be applied to the transmitters shown in FIGS. 3, 6 and 7.

The combiner shown in FIG. 8 is composed of a plurality of transmission lines each of which receives the output signal from a different digital transmitter at one ends while the other ends of the transmission lines are connected to each other. Each transmission line is formed to have a length of the quarter wavelength of the carrier frequency included in the ratio signal output from the digital transmitter. The transmission line having a length of the quarter wavelength of the carrier frequency will be referred to hereinbelow as "$\lambda/4$ transmission line".

The $\lambda/4$ transmission line converts the input voltage signal V(t) to current signal I(t) represented by the following equation and outputs the current.

$$I(t) = V(t)/z_0 \bullet\bullet\bullet (10),$$

where $z_0$ is the characteristic impedance of the $\lambda/4$ transmission line.

In the combiner shown in FIG. 8, when V1(t) represents the voltage signal input to one of the $\lambda/4$ transmission lines and V2(t) represents the voltage signal input to the other $\lambda/4$ transmission line, the first $\lambda/4$ transmission line outputs current signal I1(t) and the other $\lambda/4$ transmission line outputs current signal I2(t). Herein, when the load connected to the output of the combiner shown in FIG. 8 is denoted by Rload, voltage Vload(t) applied to the load is written from the above Eq. (10) as the following equation (11).

$$Vload(t) = (V1(t) + V2(t)) \bullet Rload/z_0 \bullet\bullet\bullet (11).$$

Eq. (11) shows that a voltage proportional to the sum of signal voltages V1(t) and V2(t) input to the combiner shown in FIG. 8 is supplied to the load.

The combiner shown in FIG. 9 shows a configuration in which band bass filters that allow the desired radio signal band to pass therethrough are connected at the upstream stage of the combiner shown in FIG. 8.

The band pass filter may use inductor L and capacitor C connected in series as shown in FIG. 9, for example. Use of the combiner shown in FIG. 9 makes it possible to prevent noise other than the desired signal band being mixed into the transmission line. Here, when the combiner is realized by the transformer shown in FIG. 3 or 7, the band pass filter may be inserted between the combiner and each digital transmitter.

Combiner 30 is not limited to the configurations shown in FIGS. 3, 6, 8 and 9, but may use a well-known combiner such as a Wilkinson combiner or the like.

(The Second Exemplary Embodiment)

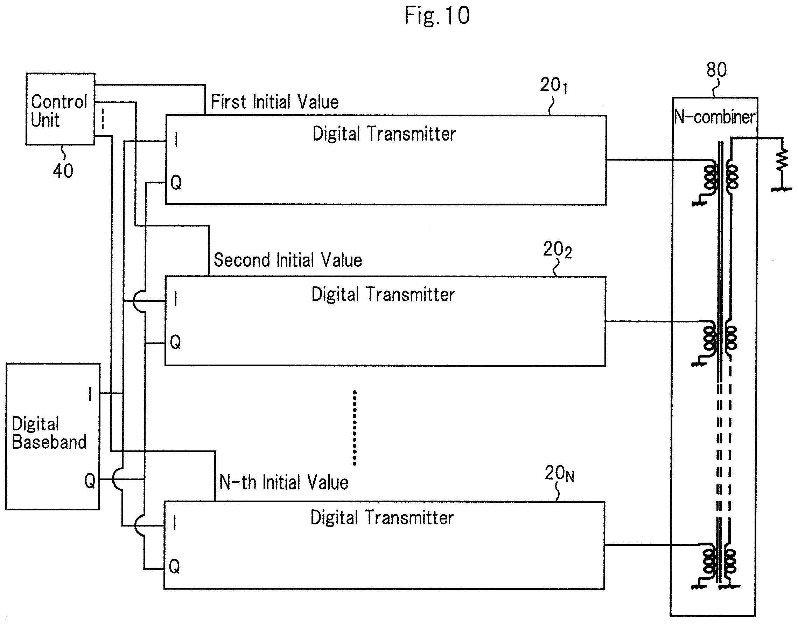

FIG. 10 is a block diagram showing one configurational example of a transmitter of the second exemplary embodiment.

The transmitter of the second exemplary embodiment includes N (N is an integer equal to or greater than 2) digital transmitters and is configured to combine the output signals from the individual digital transmitters through N-combiner 80 to output the combined result to the load.

The transmitter shown in FIG. 10 corresponds to the configuration shown in FIG. 3 in which the number of digital transmitters 20 is further increased. The configuration of each of digital transmitters $20_1$ to $20_N$ is the same as the transmitter in the first exemplary embodiment. Input to N digital transmitters $20_1$ to $20_N$ in the initial state are initial values (the first to N-th initial values) generated at control unit 40 to be different from each other.

N-combiner 80 may be realized, for example, by a transformer having N primary windings to which the output signals from digital transmitters $20_1$ and $20_N$ are individually input and N secondary windings that are provided corresponding to the primary windings, connected in series.

When N digital transmitters $20_1$ to $20_N$ provided for the transmitter shown in FIG. 10 are named k-th digital transmitters (k is an integer from 1 to N), output signal Tx_k(t) from the _k-th digital transmitter $20_k$ is represented by the following equation (12).

$$\text{Tx\_k(t)} = \text{S(t)} + \text{N\_k(t)} \cdots (12)$$

where N_k(t) is the quantized noise generated at the $\Delta\Sigma$ modulator arranged in the k-th digital transmitter $20_k$.

N-combiner 80 combines the output signals from digital transmitters $20_1$ to $20_N$ and outputs the combined result. The output voltage VNcom(t) from this N-combiner 80 is represented by the following equation (13).

$$\text{VNcom(t)} = \text{N} \cdot \text{S(t)} + \text{N\_1(t)} + \text{N\_2(t)} + \cdots + \text{N\_k(t)} \cdots (13)$$

The signal-to-noise power ration $SNR_{Ncom}$ of VNcom(t) in the output from N-combiner 80 is represented by the following equation (14)

[Math 10]

$$SNR_{Ncom} = N^2 \cdot \overline{S(t)^2} / \overline{\left(\sum_{k=1}^{N} N\_k(t)\right)^2} \cdots (14)$$

Here, since the time average of the product of N_p(t) and N_q(t) (p and q are different integers) becomes zero based on the statistic characters of noise, the denominator on the right side of Eq. (14) can be expanded as Eq. (15).

[Math 11]

$$\overline{\left(\sum_{k=1}^{N} N\_k(t)\right)^2} = N \cdot \overline{N\_1(t)^2} \cdots (15)$$

Here, it is assumed that the time average of N_k(t)$^2$ is constant without depending on k.

From the above Eq. (15), Eq. (14) can be rewritten as the following equation (16).

[Math 12]

$$SNR_{Ncom} = N \cdot \overline{S(t)^2} / \overline{N\_1(t)^2} \quad \cdots(16)$$

As described above, since the signal-to-noise power ratio in the output from the _k-th digital transmitter $20_k$ is represented by the aforementioned Eq. (2), Eq. (16) indicates that the signal-to-noise power ratio in the output from N-combiner 80 comes to N times of the signal-to-noise power ratio in the output of one digital transmitter.

That is, when the output signals from multiple digital transmitters each having a $\Delta\Sigma$ modulator that receives an initial value different from the others are combined, the desired signal power is amplified in proportion to the square of the number of combined signals, whereas the quantized noise arising at $\Delta\Sigma$ modulators is amplified in proportion to the number of combined signals. Accordingly, the signal-to-noise power ratio improves in proportion to the number of combined signals.

N digital transmitters $20_1$ to $20_N$ all have the same configuration. The power supply voltage to be used for binary class-D amplifier of each of digital transmitters $20_1$ to $20_N$ is also equal to that of the others. As a result, it is possible to use a single common power supply for the binary class-D amplifier of every digital transmitter.

Accordingly, similarly to the first exemplary embodiment, also in the transmitter shown in FIG. 10 it is possible to obtain a transmitter that can achieve an improved signal-to-noise power ratio without using a multilevel class-D amplifier that requires a plurality of power supplies. Further, it is possible to hold down the sampling frequency or the over sampling ratio of the $\Delta\Sigma$ modulators that is required to obtain the equivalent signal-to-noise power ratio, and therefore decrease power consumption of the $\Delta\Sigma$ modulators and reduce power consumption of the transmitter as a whole.

Here, N digital transmitters $20_1$ to $20_N$ provided for the transmitter shown in FIG. 10 may be replaced by the configuration shown in FIG. 6 that includes binary output RF signal generator 52 and class-D amplifier 53.

Further, the configuration shown by this exemplary embodiment can also be applied to a transmitter that includes an RF signal generator with a multilevel $\Delta\Sigma$ modulator, and a multilevel class-D amplifier. For example, N digital transmitters $20_1$ to $20_N$ provided for the transmitter shown in FIG. 10 may be replaced by the configuration shown in FIG. 7 that includes the multilevel output RF signal generator and multilevel class-D amplifier, or by the configuration that includes the multilevel output RF signal generator and multilevel class-D amplifier shown in FIG. 2.

Moreover, though FIG. 10 shows a configurational example in which the initial values are supplied to the input terminals of the $\Delta\Sigma$ modulators, the initial values may be supplied to the internal nodes of the $\Delta\Sigma$ modulators. In this case, as shown in FIGS. 5(a) to 5(c), a changeover switch may be inserted in the feedback loop forming an integrator in the $\Delta\Sigma$ modulator to thereby input the initial value, or a change over switch may be inserted in other internal nodes of $\Delta\Sigma$ modulators to input initial values.

Further, N-combiner 80 may be realized by the configuration that includes the $\lambda/4$ transmission lines shown in FIG. 8 or that includes the band pass filters and $\lambda/4$ transmission lines shown in FIG. 9. In this case, a $\lambda/4$ transmission line and a band pass filter may and should be disposed for every output from N digital transmitters $20_1$ to $20_N$. Moreover, N-combiner 80 may be realized by connecting well-known combiners in a cascade manner as in a Wilkinson combiner or the like.

(The third Exemplary Embodiment)

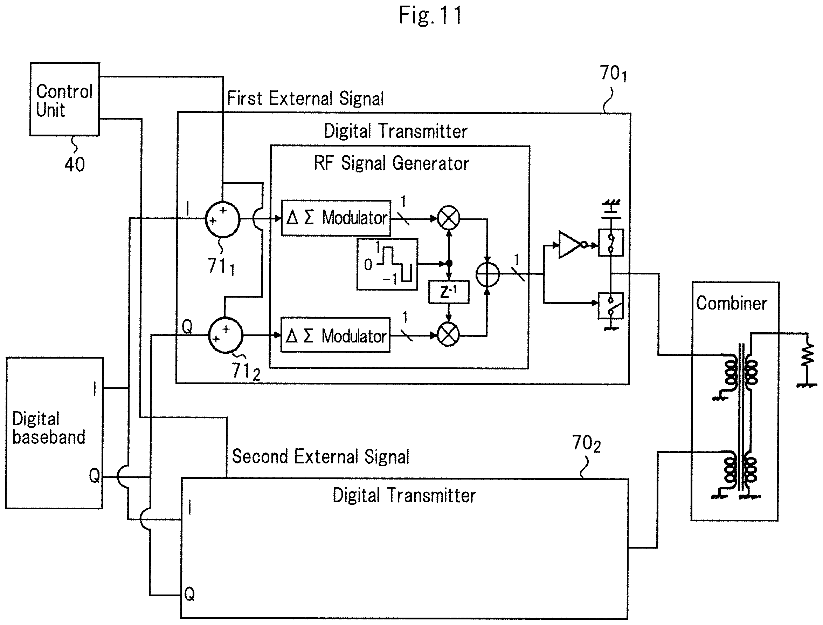

FIG. 11 is a block diagram showing one configurational example of a transmitter of the third exemplary embodiment.

The transmitter of the third exemplary embodiment is configured such that in the transmitter shown in FIG. 3, changeover switches $21_1$ and $21_2$ are replaced by adders $71_1$ and $71_2$ so that, instead of the fixed initial values, the first external signal and second external signal generated outside are supplied to the RF signal generator via adders $71_1$ and $71_2$. That is, in the present exemplary embodiment, adders $71_1$ and $71_2$ are used as the input terminals to the $\Delta\Sigma$ modulators in the RF signal generator or the input means for supplying external signals to the internal nodes of the $\Delta\Sigma$ modulators. The first external signal to be input to digital transmitter $70_1$ and the second external signal to be input to digital transmitter $70_1$ should be different from each other. The first external signal and the second external signal are generated and supplied by, for example control unit 40, similar to the first and second exemplary embodiment.

In the transmitter shown in FIG. 11, output signal Tx11(t) from digital transmitter $70_1$ contains radio signal S(t), quantized noise N11(t) that arises at $\Delta\Sigma$ modulators and signal Ex11(t) supplied from the outside. Accordingly, output signal Tx11(t) from the digital transmitter can be represented by the following equation (17).

$$Tx11(t) = S(t) + Ex11(t) + N11(t) \quad \cdots (17)$$

Similarly, output signal Tx12(t) from digital transmitter $70_2$ contains radio signal S(t), quantized noise N12(t) that arises at $\Delta\Sigma$ modulators and signal Ex12(t) supplied from the outside. Accordingly, output signal Tx12(t) from digital transmitter $70_2$ can be represented by the following equation (18).

$$Tx12(t) = S(t) + Ex12(t) + N12(t) \bullet\bullet\bullet (18)$$

Signal-to-noise power ratio SNR11 in the output from digital transmitter $70_1$ can be represented by the following equation (19) when Ex11(t) is negligible relative to S(t) or when the condition that the signal bands of the two are far enough apart holds.
[Math 13]

$$SNR11 = \overline{S(t)^2} / \overline{N11(t)^2} \quad \cdots(19)$$

Similarly, signal-to-noise power ratio SNR12 in the output from digital transmitter $70_2$ can be represented by the following equation (20).
[Math 14]

$$SNR12 = \overline{S(t)^2} / \overline{N12(t)^2} \quad \cdots(20)$$

Here, as shown in the above Eq. (103), the quantized noise arising at a $\Delta\Sigma$ modulator depends on the input signal to the $\Delta\Sigma$ modulator. Further, because a different external signal is supplied to each of the $\Delta\Sigma$ modulators, N11(t) and N12(t) are not equal.

When Com11(t) represents the output from the combiner and SNRcom11 represents the signal-to-noise power ratio in the output from the combiner, the above equations (5) to (9) with N1(t), N2(t), Com(t) and SNRcom(t) replaced by N11(t), N12(t), Com11(t) and SNRllcom(t) also hold.

That is, the following equation (21) holds in place of Eq. (9)
[Math 15]

$$SNR_{com}11 = 2 \cdot \overline{S(t)^2} / \overline{N11(t)^2} \quad \cdots(21)$$

As understood from Eq. (21), signal-to-noise power ratio SNRcom11 in the output from the combiner doubles signal-to-noise power ratio SNR11 in the output from digital transmitter $70_1$ (=signal-to-noise power ratio SNR12 in the output from digital transmitter $70_2$).

That is, compared to the configuration that includes only a single digital transmitter and that is supplied with no external signal, the signal-to-noise power ratio is improved in the transmitter shown in FIG. 11.

Further, digital transmitters $70_1$ and $70_2$ shown in FIG. 11 have the same configuration, and the binary class-D amplifiers of these digital transmitters use the same power supply voltage. Accordingly, it is possible to use a single common power supply voltage for the binary class-D amplifiers.

As a result, also in the transmitter shown in FIG. 11, similarly to the first exemplary embodiment it is possible to obtain a transmitter that can achieve an improved signal-to-noise power ratio without using a multilevel class-D amplifier that requires a plurality of power supplies. Further, it is possible to hold down the sampling frequency or the over sampling ratio of the $\Delta\Sigma$ modulators that is required to obtain the equivalent signal-to-noise power ratio, and therefore decrease power consumption of the $\Delta\Sigma$ modulators and reduce power consumption of the transmitter as a whole.

Here, in this case when a signal takes a significant value in the initial stage and then becomes zero (0) after the initial stage has been supplied as an external signal, the external signal will assume that the signal, which took a significant value at the initial stage, is a signal that can only offer an initial value to the $\Delta\Sigma$ modulator. In this case, the configuration shown in FIG. 11 is substantially equivalent to the first exemplary embodiment.

Digital transmitters $70_1$ and $70_2$ included in the transmitter shown in FIG. 11 may be replaced by a configuration that includes binary output RF signal generator 52 and class-D amplifier 53 shown in FIG. 6.

Further, the configuration shown by this exemplary embodiment can also be applied to a transmitter that includes an RF signal generator with a multilevel $\Delta\Sigma$ modulator, and a multilevel class-D amplifier. For example, digital transmitters $70_1$ and $70_2$ provided for the transmitter shown in FIG. 11 may be replaced by the configuration shown in FIG. 7 that includes the multilevel output RF signal generator and multilevel class-D amplifier, or by the configuration that includes the multilevel output RF signal generator and multilevel class-D amplifier shown in FIG. 2. Also in this case, the changeover switches need to be replaced with adders and, instead of initial values, external signals need to be supplied to $\Delta\Sigma$ modulators of RF signal generators.

Further, as in the transmitter shown in FIG. 10, digital transmitter $70_1$ of the transmitter shown in FIG. 11 that prepares N, may be arranged so that the output signals from these N digital transmitters may be combined by N-combiner 80.

Moreover, though FIG. 11 shows a configurational example in which the external signals are supplied to the input terminals of the $\Delta\Sigma$ modulators, the external signals may be supplied to the internal nodes of the $\Delta\Sigma$ modulators. In this case, as shown in FIGS. 5(a) to 5(c), the external signals may be input by inserting adder 71 to the feedback loop that forms an integrator in the $\Delta\Sigma$ modulator, or by inserting adder 71 in the other internal nodes of $\Delta\Sigma$ modulators.

Further, N-combiner 30 may be realized by the configuration that includes $\lambda/4$ transmission lines shown in FIG. 8 or that includes band pass filters and $\lambda/4$ transmission lines shown in FIG. 9, or may be realized with well-known combiners as in a Wilkinson combiner or the like.

Although the present invention has been explained with reference to the exemplary embodiments, the present invention should not be limited to the above exemplary embodiments. Various modifications that can be understood by those skilled in the art may be made to the structures and details of the present invention within the scope of the present invention which is defined by the claims.

This application is based upon and claims the benefit of priority from Japanese patent application No. 2012-202592, filed on September 14, 2012.

**Claims**

1.    A transmitter comprising:

a plurality of digital transmitters ($50_1$; $50_2$), each comprising a delta sigma modulator (221,521), wherein the delta sigma modulators are configured to perform delta-sigma modulation on a same baseband signal provided by a baseband circuit (11) and wherein each of the digital transmitters ($50_1$; $50_2$) includes a class-D amplifier electrically coupled to the output of the respective sigma delta modulator;

a combiner (30) that is configured to combine output signals from the plurality of digital transmitters ($50_1$; $50_2$) and to output a combined result thereof;

a control unit (40) that is configured to generate initial values different for every digital transmitter ($50_1$; $50_2$), to be supplied to each of the plurality of digital transmitters ($50_1$; $50_2$); and

a plurality of changeover switches (51) each of which is connected between outputs of the baseband circuit (11) and an input terminal or an internal node of the delta-sigma modulator (521, 221) in each digital transmitter ($50_1$; $50_2$) and being configured to supply one of the initial values that is different for every digital transmitter ($50_1$; $50_2$), to the input terminal or the internal node of the delta-sigma modulator (521,221) that performs the delta-sigma modulation,

wherein each of the plurality of changeover switches (51) is configured to supply a respective one of the initial values of an initial state of every digital transmitter ($50_1$; $50_2$) and the baseband signal after the initial state in accordance with a control signal output from the control circuit (40), wherein each initial value is a fixed value.

2.    The transmitter according to claim 1, wherein the class-D amplifier is a binary class-D amplifier comprising:

a power supply that outputs d.c. voltage; and

switching elements interposed between the power supply and an output terminal and between the output terminal and the ground potential.

3.    The transmitter according to claim 1 or 2, wherein the class-D amplifier is a multilevel class-D amplifier comprising:

a plurality of power supplies ($V_0 \sim V_N$) in which the output d.c. voltage of each power supply ($V_0 \sim V_N$) differs from the other power supply ($V_0 \sim V_N$); and

a plurality of switching elements interposed between the plural power supplies and an output terminal and between the output terminal and the ground potential.

4.    The transmitter according to any one of claims 1 to 3, wherein the delta sigma modulators comprise:

a delta-sigma modulator ($221_1$; $221_2$) that is configured to receive

an amplitude signal extracted from two orthogonal signals as the baseband signals and a phase signal extracted from the orthogonal signals and to perform delta-sigma modulation on the amplitude signal, using the phase signal as the clock signal; and

a multiplier ($222_1$; $222_2$) that is configured to multiply the output signal from the delta-sigma modulator ($521,221_1$; $221_2$) and the phase signal.

**5.** The transmitter according to any one of claims 1 to 3, wherein the delta sigma modulators comprise:

two delta-sigma modulators ($221_1$; $221_2$) that are configured to receive two orthogonal signals as the baseband signals and to perform delta-sigma modulation on the two orthogonal signals;

frequency converters ($222_1$; $222_2$) that are configured to upconvert the output signals from the two delta-sigma modulators ($221_1$; $221_2$) to the desired radio signal frequency; and,

an adder (91) that is configured to add up the output signals from the frequency converters.

**6.** The transmitter according to any one of claims 1 to 5, wherein the combiner (30) includes a transformer in which a plurality of primary windings, to which the output signal for every digital transmitter ($50_1$; $50_2$; $70_1$; $70_2$) is input, and a plurality of secondary windings arranged corresponding to the primary windings are connected in series.

**7.** The transmitter according to any one of claims 1 to 5, wherein the combiner (30) includes a plurality of transmission lines each of which receives the output signal from a different digital transmitter ($50_1$; $50_2$; $70_1$; $70_2$) at one end while the other ends of transmission lines are connected to each other.

**8.** The transmitter according to claim 7, wherein the transmission line is formed with a length of one quarter wavelength of the carrier frequency contained in the radio signal.

**9.** The transmitter according to any one of claims 1 to 8, wherein the combiner (30) includes a band-pass filter that is configured to permit a desired radio signal to pass therethrough.

**Patentansprüche**

**1.** Sender, der aufweist:

mehrere digitale Sender ($50_1$; $50_2$), die jeweils einen Delta-Sigma-Modulator ($221,521$) aufweisen, wobei die Delta-Sigma-Modulatoren konfiguriert sind, eine Delta-Sigma-Modulation an einem selben Basisbandsignal durchzuführen, das durch eine Basisbandschaltung (11) bereitgestellt wird, und wobei jeder der digitalen Sender ($50_1$; $50_2$) einen Klasse-D-Verstärker aufweist, der elektrisch mit dem Ausgang des jeweiligen Delta-Sigma-Modulators gekoppelt ist;

einen Kombinator (30), der konfiguriert ist, Ausgangssignale aus den mehreren digitalen Sendern ($50_1$; $50_2$) zu kombinieren und deren kombiniertes Resultat auszugeben;

eine Steuereinheit (40), die konfiguriert ist, Anfangswerte zu erzeugen, die sich für jeden digitalen Sender ($50_1$, $50_2$) unterscheiden, die an jeden der mehreren digitalen Sender ($50_1$; $50_2$) geliefert werden sollen; und

mehrere Umschalter (51), von denen jeder zwischen Ausgänge der Basisbandschaltung (11) und einem Eingangsanschluss oder einen internen Knoten des Delta-Sigma-Modulators ($521$, $221$) in jedem digitalen Sender ($50_1$, $50_2$) geschaltet und konfiguriert ist, einen der Anfangswerte, die sich für jeden digitalen Sender ($50_1$, $50_2$) unterscheiden, an den Eingangsanschluss oder den internen Knoten des Delta-Sigma-Modulators ($521,221$) zu liefern, der die Delta-Sigma-Modulation durchführt,

wobei jeder der mehreren Umschalter (51) konfiguriert ist, einen jeweiligen der Anfangswerte eines Anfangszustands von jedem digitalen Sender ($50_1$; $50_2$) und das Basisbandsignal nach dem Anfangszustand in Übereinstimmung mit einem Steuersignal zu liefern, das aus der Steuerschaltung (40) ausgegeben wird, wobei jeder Anfangswert ein fester Wert ist.

**2.** Sender nach Anspruch 1, wobei der Klasse-D-Verstärker ein binärer Klasse-D-Verstärker ist, der aufweist:

eine Stromversorgung, die eine Gleichspannung ausgibt; und

Schaltelemente, die zwischen die Stromversorgung und einen Ausgangsanschluss und zwischen dem Ausgangsanschluss und dem Massepotential angeordnet sind.

3. Sender nach Anspruch 1 oder 2, wobei der Klasse-D-Verstärker ein Mehrpegel-Klasse-D-Verstärker ist, der aufweist:

mehrere Stromversorgungen ($V_0 \sim V_N$), wobei sich die Ausgangsgleichspannung jeder Stromversorgung ($V_0 \sim V_N$) von der anderen Stromversorgung ($V_0 \sim V_N$) unterscheidet; und

mehrere Schaltelemente, die zwischen den mehreren Stromversorgungen und einem Ausgangsanschluss und zwischen dem Ausgangsanschluss und dem Massepotential angeordnet sind.

4. Sender nach einem der Ansprüche 1 bis 3, wobei die Delta-Sigma-Modulatoren aufweisen:

einen Delta-Sigma-Modulator ($221_1$; $221_2$), der konfiguriert ist, ein Amplitudensignal, das aus zwei orthogonalen Signalen als die Basisbandsignale extrahiert wird, und ein Phasensignal zu empfangen, das aus den orthogonalen Signalen extrahiert wird, und eine Delta-Sigma-Modulation am Amplitudensignal durchzuführen, wobei das Phasensignal als das Taktsignal verwendet wird; und

einen Multiplizierer ($222_1$; $222_2$), der konfiguriert ist, das Ausgangssignal aus dem Delta-Sigma-Modulator ($521$, $221_1$; $221_2$) und das Phasensignal zu multiplizieren.

5. Sender nach einem der Ansprüche 1 bis 3, wobei die Delta-Sigma-Modulatoren aufweisen:

zwei Delta-Sigma-Modulatoren ($221_1$; $221_2$), die konfiguriert sind, zwei orthogonale Signale als die Basisbandsignale zu empfangen und eine Delta-Sigma-Modulation an den zwei orthogonalen Signalen durchzuführen; Frequenzumsetzer ($222_1$; $222_2$), die konfiguriert sind, die Ausgangssignale aus den beiden Delta-Sigma-Modulatoren ($221_1$; $221_2$) auf die gewünschte Funksignalfrequenz aufwärts umzusetzen; und, einen Addierer (91), der konfiguriert ist, die Ausgangssignale aus dem Frequenzumsetzer zu addieren.

6. Sender nach einem der Ansprüche 1 bis 5, wobei der Kombinator (30) einen Transformator aufweist, in dem mehrere Primärwicklungen, in die das Ausgangssignal für jeden digitalen Sender ($50_1$; $50_2$; $70_1$; $70_2$) eingegeben wird, und mehrere Sekundärwicklungen, die entsprechend zu den Primärwicklungen angeordnet sind, in Reihe geschaltet sind.

7. Sender nach einem der Ansprüche 1 bis 5, wobei der Kombinator (30) mehrere Übertragungsleitungen aufweist, von denen jede das Ausgangssignal aus einem anderen digitalen Sender ($50_1$; $50_2$; $70_1$; $70_2$) an einem Ende empfängt, während die anderen Enden der Übertragungsleitungen miteinander verbunden sind.

8. Sender nach Anspruch 7, wobei die Übertragungsleitung mit einer Länge von einer Viertelwellenlänge der Trägerfrequenz ausgebildet ist, die im Funksignal enthalten ist.

9. Sender nach einem der Ansprüche 1 bis 8, wobei der Kombinator (30) einen Bandpassfilter aufweist, der konfiguriert ist, ein erwünschtes Funksignal dort hindurch gehen zu lassen.

## Revendications

1. Émetteur, comprenant :

une pluralité d'émetteurs numériques ($50_1$ ; $50_2$) comprenant chacun un modulateur delta-sigma (221,521), les modulateurs delta-sigma étant prévus pour exécuter une modulation delta-sigma sur un même signal de bande de base délivré par un circuit de bande de base (11) et chacun des émetteurs numériques ($50_1$ ; $50_2$) comprenant un amplificateur de classe D relié électriquement à la sortie du modulateur delta-sigma correspondant ;
un synthétiseur (30) prévu pour synthétiser des signaux de sortie de la pluralité d'émetteurs numériques ($50_1$ ; $50_2$) et pour émettre un résultat de synthétisation de ceux-ci ;
une unité de commande (40) prévue pour générer des valeurs initiales différentes pour chaque émetteur numérique ($50_1$ ; $50_2$) à transmettre à chacun des émetteurs de la pluralité d'émetteurs numériques ($50_1$ ; $50_2$) ; et
une pluralité d'inverseurs (51) dont chacun est connecté entre des sorties du circuit de bande de base (11) et une borne d'entrée ou un noeud interne du modulateur delta-sigma (521, 221) dans chaque émetteur numérique ($50_1$ ; $50_2$), et prévus pour transmettre une des valeurs initiales différente pour chaque émetteur numérique ($50_1$ ; $50_2$) à la borne d'entrée ou au noeud interne du modulateur delta-sigma (521, 221) exécutant la modulation delta-sigma,
où chacun des inverseurs de la pluralité d'inverseurs (51) est prévu pour transmettre une des valeurs initiales d'un état initial de chaque émetteur numérique ($50_1$ ; $50_2$) et le signal de bande de base consécutif à l'état initial en fonction d'une sortie de signal de commande du circuit de commande (40), chaque valeur initiale étant une valeur fixe.

2. Émetteur selon la revendication 1, où l'amplificateur de classe D est un amplificateur binaire de classe D comprenant :

une alimentation en courant sortant une tension continue ; et
des éléments de commutation intercalés entre l'alimentation en courant et une borne de sortie et entre la borne de sortie et le potentiel de terre.

3. Émetteur selon la revendication 1 ou la revendication 2, où l'amplificateur de classe D est un amplificateur multiniveaux de classe D comprenant :

une pluralité d'alimentations en courant ($V_0 \sim V_N$), la tension continue de sortie de chaque alimentation en courant ($V_0 \sim V_N$) différant des autres alimentations en courant ($V_0 \sim V_N$) ; et
une pluralité d'éléments de commutation intercalés entre les plusieurs alimentations en courant et une borne de sortie, et entre la borne de sortie et le potentiel de terre.

4. Émetteur selon l'une des revendications 1 à 3, où les modulateurs delta-sigma comprennent :

un modulateur delta-sigma ($221_1$ ; $221_2$) prévu pour recevoir un signal d'amplitude extrait de deux signaux orthogonaux en tant que signaux de bande de base et un signal de phase extrait des signaux orthogonaux, et pour exécuter une modulation delta-sigma sur le signal d'amplitude au moyen du signal de phase en tant que signal d'horloge ; et
un multiplicateur ($222_1$ ; $222_2$) prévu pour multiplier le signal de sortie du modulateur delta-sigma ($521,221_1$ ; $221_2$) et le signal de phase.

5. Émetteur selon l'une des revendications 1 à 3, où les modulateurs delta-sigma comprennent :

deux modulateurs delta-sigma ($221_1$ ; $221_2$) prévus pour recevoir deux signaux orthogonaux en tant que signaux de bande de base et pour exécuter une modulation delta-sigma sur les deux signaux orthogonaux ;
des convertisseurs de fréquence ($222_1$ ; $222_2$) prévus pour une conversion ascendante des signaux de sortie des deux modulateurs delta-sigma ($221_1$ ; $221_2$) à la fréquence de signal radio souhaitée ; et
un additionneur (91) prévu pour additionner les signaux de sortie des convertisseurs de fréquence.

6. Émetteur selon l'une des revendications 1 à 5, où le synthétiseur (30) comprend un transformateur où une pluralité d'enroulements primaires auxquels est transmis le signal de sortie pour chaque émetteur numérique ($50_1$ ; $50_2$ ; $70_1$ ; $70_2$) et une pluralité d'enroulements secondaires disposés de manière correspondante aux enroulements primaires sont connectés en série.

7. Émetteur selon l'une des revendications 1 à 5, où le synthétiseur (30) comprend une pluralité de lignes de transmission dont chacune reçoit le signal de sortie d'un émetteur numérique ($50_1$ ; $50_2$ ; $70_1$ ; $70_2$) différent à une extrémité, les autres extrémités des lignes de transmission étant reliées les unes aux autres.

8. Émetteur selon la revendication 7, où la ligne de transmission est formée avec une longueur d'un quart de la longueur d'onde de la fréquence porteuse contenue dans le signal radio.

9. Émetteur selon l'une des revendications 1 à 8, où le synthétiseur (30) comprend un filtre passe-bande prévu pour permettre le passage d'un signal radio souhaité.

Fig.1

Power Supply

Fig.2

Fig.3

Control Unit

40

First Initial Value

$20_1$

Digital Transmitter

RF Signal Generator

22

23

$221_1$

Δ Σ Modulator

$222_1$

$223_1$

$Z^{-1}$

224

$21_1$

I

$21_2$

Q

$221_2$

Δ Σ Modulator

$222_2$

30

Combiner

Digital Baseband

10

I

Q

Second Initial Value

$20_2$

Digital Transmitter

I

Q

EP 2 897 296 B1

Fig.4

Fig.5

(a)

(b)

(c)

Fig.6

Fig.6 — Digital transmitter block diagram with Control Unit (40), Digital Baseband (11), Digital Transmitters (50₁, 50₂), RF Signal Generator (52), ΔΣ Modulator (521), IQ Modulator (522), and Combiner (30).

EP 2 897 296 B1

Fig.7

Fig.8

V1(t) —— | λ/4 |

V2(t) —— | λ/4 |

Fig.9

V1(t) —— | BPF | —— | λ/4 |

V2(t) —— | BPF | —— | λ/4 |

Fig.10

EP 2 897 296 B1

Fig. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2011077979 A
- WO 2001078120 A
- JP 2001265395 A
- EP 1168632 A1
- JP 2012202592 A

### Non-patent literature cited in the description

- **SHEHATA K.** *An FPGA based 1-bit all digital transmitter employing Delta-Sigma Modulation with RF output for SDR*
- **S. HORI ; K. KUNIHIRO ; K. TAKAHASHI ; M. FUKAISHI.** A 0.7-3GHz envelope delta-sigma modulator using phase modulated carrier clock for multi-mode/band switching amplifiers. *IEEE Radio Frequency Integrated Circuits Symposium Digest,* June 2011, 35-38